# EUROPEAN PATENT SPECIFICATION

(11) **EP 3 961 925 B1**
(45) Date of publication and mention of the grant of the patent: **09.12.2026**
(21) Application number: 21193142.3
(22) Date of filing: 25.08.2021
(51) Int. Cl.: H03K 17/80, H03K 17/90, G01R 15/20

(54) **CURRENT CONTROLLING ELEMENT BASED ON SATURATION OF A MAGNETIC CIRCUIT**
STROMSTEUERUNGSELEMENT BASIEREND AUF DER SÄTTIGUNG EINES MAGNETKREISES
ÉLÉMENT DE RÉGULATION DE COURANT BASÉ SUR LA SATURATION D'UN CIRCUIT MAGNÉTIQUE

(30) Priority: 28.08.2020 GB 202013521
(43) Date of publication of application: 02.03.2022
(73) Proprietor: Eaton Intelligent Power Limited, Dublin 4 (IE)
(72) Inventor: Kopejtko, Petr, 19000 Prague (CZ)
(74) Representative: Derry, Paul Stefan

(56) References cited:
- EP-A1- 2 442 117
- US-A- 5 564 194
- US-B1- 6 710 587

## Description

### TECHNICAL FIELD

The invention relates to a current controlling element, which comprises a first magnetic core forming a magnetic circuit, a coil, which is designed to generate a magnetic flux in the first magnetic core when it its energized, and a second magnetic core, which is arranged at a distance from the first magnetic core.

### BACKGROUND ART

Current controlling elements are known in prior art in various embodiments, like as relays, transistor-switches, thyristor-switches, optocoupler-switches and so on. Some provide galvanic separation, some are contactless, some have a very steep switching characteristic and some are suitable for very high currents. However, known devices suffer from various limitations, and there is missing a very robust device for very high currents, which can provide galvanic separation which is contactless, does not require additional electronic, does not contain moving parts, has small conduction losses and which provides steep switching or current limiting characteristics.

US 6 710 587 B1 is considered to be relevant prior art as it is structurally similar to the current controlling element and discloses a current sensing element which comprises a first magnetic core forming a magnetic circuit, a coil, which is designed to generate a magnetic flux in the first magnetic core when it is energized, and a second magnetic core, which is arranged at a distance from the first magnetic core and arranged to receive a magnetic flux from the first magnetic core if during operation an imbalance occurs in the magnetic circuit due to a fault, where said flux is detected by a magneto-resistive sensor.

### DISCLOSURE OF INVENTION

Accordingly, an object of the invention is the provision of an improved current controlling element. In particular, a current controlling element shall be provided, which overcomes the above limitations.

The object of the invention is solved by an arrangement as disclosed in the opening paragraph, which additionally comprises a magnetoresistive conductor arranged in a first air gap between the first magnetic core and the second magnetic core.

The current controlling element functions as follows: When the current through the coil is increased, the magnetic flux through the first magnetic core is increased as well. At some point, the first magnetic core is saturated and an additional magnetic flux caused by an additional current through the coil flows outside the first magnetic core. The current controlling element is designed in a way that said additional flux is guided through the second magnetic core causing the magnetoresistive conductor being exposed to magnetic field as well. Accordingly, the resistance of the magnetoresistive conductor is changed and hence a current through the magnetoresistive conductor is changed. The magnetoresistive conductor (in particular its active parts, e.g. its semiconductor structure) beneficially is placed in a region of a high magnetic flux (i.e. a high concentration of flux lines).

The point or range when the first magnetic core saturates and the magnetic field emanates into the second magnetic core is chosen in a way that the current linked to this magnetic flux corresponds to a switching threshold or switching range of the current controlling element. In particular, the nominal switching current of the current controlling element is at said switching threshold.

So, generally, a "nominal switching current" Inom for a current I through the coil or a "switching threshold" can be defined. Both terms can interchangeably used throughout this disclosure. The magnetic flux mainly exists in the first magnetic core below the nominal switching current Inom or the switching threshold, and it emanates into the second magnetic core at and above the nominal switching current Inom or the switching threshold. Hence, there is a substantial traverse magnetic field through the magnetoresistive conductor above the nominal switching current Inom or above the switching threshold influencing the resistance of the magnetoresistive conductor.

The current controlling element can comprise a housing with a nominal switching current Inom for a current I through the coil or an information referring to the nominal switching current Inom printed on the housing. Such an information can be a part number or a symbol or a color associated with a particular nominal switching current Inom.

It should be noted that there is no "binary" or "digital" swap of the magnetic flux into the second magnetic core in the sense of all or nothing, but the change is continuous, but also steep depending on the design.

So, strictly speaking, it is a range where the first magnetic core saturates and the magnetic field emanates into the second magnetic core. Hence, the current controlling element is designed in a way that the current linked to this magnetic flux corresponds to a switching range of the current controlling element. In particular, the nominal switching current of the current controlling element is within said switching range.

Generally, the point or range when the first magnetic core saturates can be influenced by choosing the material and the cross section of the first magnetic core in a useful way. Lower cross sections and magnetic materials with a lower saturation flux density lead to earlier saturations and thus to a lower switching point or switching range.

Beneficially, the first magnetic core is designed in way that parts thereof, which saturate at the switching point or switching range, are arranged nearby the magnetoresistive conductor and the second magnetic core. Other parts of the first magnetic core, which saturate well above the switching point or switching range, are arranged at a greater distance from the magnetoresistive conductor and the second magnetic core. This behavior can be achieved by making the cross section of the first magnetic core smaller in a region nearby to the magnetoresistive conductor and the second magnetic core than elsewhere. Alternatively or in addition, this behavior can be achieved by using a magnetic material with a lower saturation flux density in a region nearby to the magnetoresistive conductor and the second magnetic core than elsewhere.

In particular, a cross section of a leg or a part of the first magnetic core, which is arranged nearby the magnetoresistive conductor and the second magnetic core, can be smaller than the cross section in the other legs of the first magnetic core or in other parts thereof. Alternatively or in addition, a magnetic material with a lower saturation flux density can be used for a leg or a part of the first magnetic core, which is arranged nearby the magnetoresistive conductor and the second magnetic core, and a magnetic material with a higher saturation flux density can be used in other legs or parts of the first magnetic core.

By the above measures, a current controlling element with a number of beneficial characteristics is obtained. First, a galvanic separation of the control circuit and the controlled circuit can be obtained. Second, the current controlling element is contactless. And third, there is a steep increase of the resistance of the magnetoresistive conductor when the control current reaches its switching threshold value. So, a (binary) switch on / switch off behavior can be approximated. Moreover, the disclosed current controlling element is very robust and suitable for high currents (i.e. it has a small resistance at nominal current). Hence, it qualifies well for heavy duty applications.

Generally, the first magnetic core can form a) a closed magnetic circuit without a second air gap or b) an open magnetic circuit having at least one second air gap. An air gap provides the advantage, that the current through the coil, which flows when the first magnetic core saturates, and thus the switching threshold can be controlled. The length of the second air gap preferably is chosen in a way that the first magnetic core saturates when the nominal current is reached.

In this context it is beneficial if the first magnetic core in case b) comprises a first sub part and a separate second sub part with the at least one second air gap in-between (i.e. between the first sub part and the second sub part). The second sub part is closer to the magnetoresistive conductor and the second magnetic core than the first sub part. The second sub part shall preferably saturate when the nominal current is reached, and the second sub part shall saturate after the first sub part what can be achieved by design of the length of the second air gap, design of the cross section of the first and the second sub part and/or material choice for the first and the second sub part. After the second sub part has been saturated, an additional magnetic flux is transferred into the second magnetic core. To achieve the desired function, in particular, the cross section of the second sub part can be made smaller than the cross section of the first sub part. Alternatively or in addition, magnetic material with a lower saturation flux density can be used for the second sub part, and a magnetic material with a higher saturation flux density can be used for the first sub part.

Further on, the first magnetic core in particular can form a magnetic circuit in the shape of a single ring or in the shape of multiple rings. If there is a first and a second sub part, the first sub part is shaped like an "U" in case of a single ring and shaped like an "E" or an "M" in case of a double ring magnetic circuit.

Beneficially, the resistance of the magnetoresistive conductor increases with an increase of the magnetic flux through the magnetoresistive conductor. In this way, a switch-off characteristic or current-limiting characteristic can be provided, in other words, a kind of a normally closed contact or break contact. However, in principle, the resistance of the magnetoresistive conductor may also decrease with an increase of the magnetic flux through the magnetoresistive conductor. In that way, a switch-on characteristic can be provided, in other words a kind of a normally open contact or closing contact. Generally, the resistance with no magnetic field applied is usually comparably high for the latter materials. Moreover the change of resistance for those materials usually is in the range of two orders if a comparably strong magnetic field is applied.

Further advantageous embodiments are disclosed in the claims and in the description as well as in the figures.

In a preferred embodiment of the current controlling element, the magnetoresistive conductor contacts the first magnetic core and the second magnetic core. This configuration enables good heat transfer and keeps the magnetoresistive conductor comparably cool. If there is a second sub part, the magnetoresistive conductor in particular contacts the second sub part and the second magnetic core.

Advantageously, a reluctance of the first magnetic core (alone) is at least 10 times lower than a reluctance of first magnetic core together with the second magnetic core. In this way, the magnetic flux is mainly kept within the first magnetic core up to the switching threshold.

Beneficially, the first magnetic core and/or the second magnetic core is made of Vanadium permendur. Vanadium permendur is a soft ferromagnetic alloy comprising cobalt (Co), iron (Fe) and vanadium (Va) in particular having a saturation flux of more than 2 Tesla. Generally, the material of the first magnetic core and its cross section should be designed in a way that the magnetic flux up to the switching threshold can be handled without or just low saturation. If Vanadium permendur is chosen, the cross section of the first magnetic core can be kept small. In a similar way, the second magnetic core and its cross section should be designed in a way that the magnetic flux above the switching threshold can be handled. If Vanadium permendur is chosen, the cross section of the second magnetic core can be kept small as well.

Preferably, the first sub part is made of Vanadium permendur (which has a saturation flux of around or more than 2 Tesla) and/or the second sub part is made of a Mu-metal (which is a nickel-iron soft ferromagnetic alloy and which has a saturation flux of around 1 Tesla) or of ferrite (having a saturation flux 0.5 Tesla or less). In addition, the second magnetic core can be made of Vanadium permendur, too. These materials can well support the behavior of the first magnetic core that the second sub part saturates at the nominal current and well before saturation effects occur in the first sub part.

Beneficially, the magnetoresistive conductor has a semiconductor-metal hybrid structure and operates according to the Extraordinary magnetoresistance effect. The Extraordinary magnetoresistance (EMR) is a magnetoresistance effect, which allows changes of the electrical resistance caused by the application of a magnetic field in the region of 1:10.000 and more. The effect occurs in semiconductor-metal hybrid systems when a transverse magnetic field is applied. Without a magnetic field the magnetoresistive conductor has a low-resistance. Upon application of a magnetic field the magnetoresistive conductor has a much higher electrical resistance. Accordingly, this material is suitable for the disclosed "switching" applications.

In a beneficial embodiment, the current controlling element comprises two control terminals with the coil switched in-between and two controlled current terminals with the magnetoresistive conductor switched in-between. In this way, a device is formed, by which a current in a first circuit including the magnetoresistive conductor is controlled by a current in a second circuit including the coil.

In another beneficial embodiment, the current controlling element comprises two auto current limiter terminals and a series connection of the coil and the magnetoresistive conductor switched in-between. In this way, the current in an electric circuit can be limited. Hence, the current controlling element becomes a "current limiting element" in this embodiment, e.g. a circuit breaker.

In both embodiments, it is of advantage if a resistor switched between the two controlled current terminals or between the two auto current limiter terminals. In this way, the range, in which the total resistance between the controlled current terminals or between the auto current limiter terminals varies, can be set or influenced. Moreover, without the resistor, electric energy would have to be dissipated only in magnetoresistive material what could heat it up in an undesired way and even destroy it. The resistor provides an alternative electric path for the electric (short circuit) current.

Beneficially, the current controlling element has a nominal switching current Inom for a current I through the coil, wherein
- a magnetic flux density in the first magnetic core is at least 10 times the magnetic flux density in the second magnetic core in a current range I < 0.9 · Inom and wherein
- the magnetic flux density in the second magnetic core is at least 0.5 times the magnetic flux density in the first magnetic core in a current range I > 1.1 · Inom.

By designing the first magnetic core and the second magnetic core in an appropriate way, in particular by setting air gaps accordingly and by a proper choice of cross sections and materials, the magnetic flux mainly exists in the first magnetic core below the nominal switching current Inom, and it emanates into the second magnetic core at and above the nominal switching current Inom.

### BRIEF DESCRIPTION OF DRAWINGS

The invention now is described in more detail hereinafter with reference to particular embodiments, which the invention however is not limited to.
- Fig. 1: shows a first example of a current controlling element with a closed first magnetic core without an air gap;
- Fig. 2: shows a second example of a current controlling element with a resistor switched in parallel to the magnetoresistive conductor;
- Fig. 3: shows an example of a current limiting element;
- Fig. 4: shows a current limiting element with an air gap in the first magnetic core;
- Fig. 5: shows a current limiting element with two air gaps in the first magnetic core;
- Fig. 6: shows a current limiting element, wherein the magnetoresistive conductor is in contact with the first magnetic core and the second magnetic core;
- Fig. 7: shows a current limiting element with a first sub part of the first magnetic core, which is M-shaped;
- Fig. 8: shows the magnetic flux in a current controlling element in a current range below the nominal switching current;
- Fig. 9: shows the magnetic flux in the current controlling element of Fig. 8 at the nominal switching current;
- Fig. 10: shows the magnetic flux in a current controlling element in a current range above the nominal switching current;
- Fig. 11: shows a first exemplary structure of a magnetoresistive conductor and
- Fig. 12: shows a second exemplary structure of a magnetoresistive conductor.

### DETAILED DESCRIPTION

Generally, same parts or similar parts are denoted with the same/similar names and reference signs. The features disclosed in the description apply to parts with the same/similar names respectively reference signs. Indicating the orientation and relative position (up, down, sideward, etc) is related to the associated figure, and indication of the orientation and/or relative position has to be amended in different figures accordingly as the case may be.

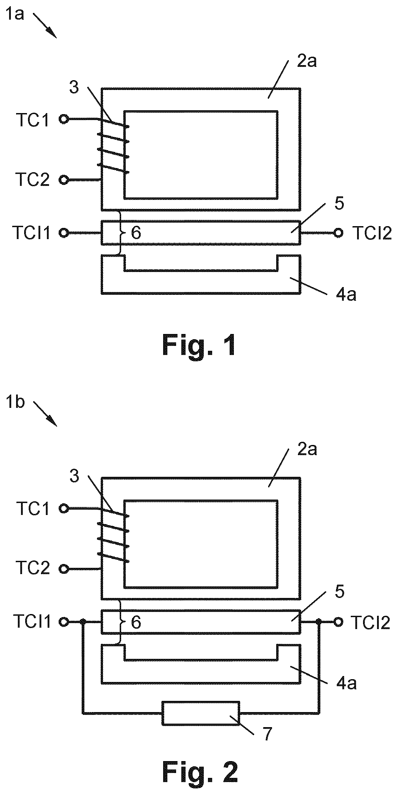

Fig. 1 shows a first example of a current controlling element 1a in schematic side view. The current controlling element 1a comprises a first magnetic core 2a forming a magnetic circuit, a coil 3, which is designed to generate a magnetic flux in the first magnetic core 2a when it its energized, and a second magnetic core 4a, which is arranged at a distance from the first magnetic core 2a. Moreover, the current controlling element 1a comprises a magnetoresistive conductor 5 arranged in a first air gap 6 between the first magnetic core 2a and the second magnetic core 4a.

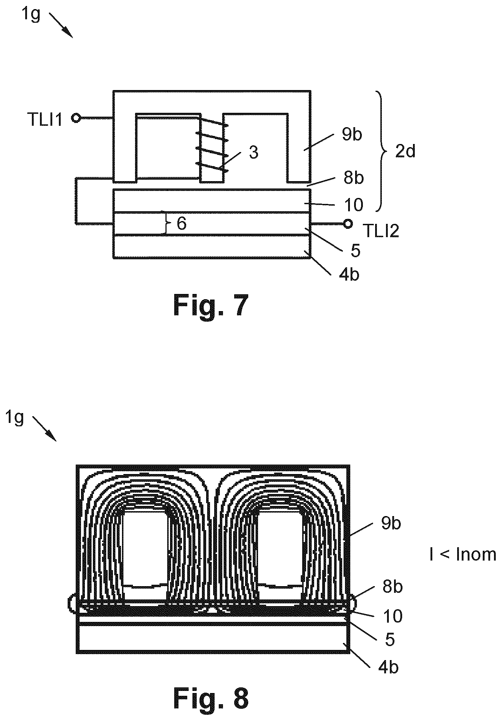

The current controlling 1a element further on has two control terminals TC1, TC2 with the coil 3 switched in-between and two controlled current terminals TCI1, TCI2 with the magnetoresistive conductor 5 switched in-between. Accordingly, a voltage between the two control terminals TC1, TC2 leads to a current through the coil 3 and in turn to a magnetic flux in the first magnetic core 2a and depending on the value of the current also in the second magnetic core 4a. In this way, the resistance between the two controlled current terminals TCI1, TCI2 is influenced or controlled what is explained in more detail by use of the Figs. 8 to 10.

It should be noted that the first magnetic core 2a is designed in way that parts thereof, which saturate at the switching threshold, are arranged nearby the magnetoresistive conductor 5 and the second magnetic core 4a. In detail, the cross section of the lower leg of the first magnetic core 2a, which is arranged nearby the magnetoresistive conductor 5 and the second magnetic core 4a, is smaller than the cross section in the other legs. Accordingly, saturation occurs earlier in the lower leg than in the other legs. Because the lower leg of the first magnetic core 2a is arranged nearby the magnetoresistive conductor 5 and the second magnetic core 4a, an additional magnetic flux reliably emanates into the second magnetic core 4a and thereby traverses the magnetoresistive conductor 5. Alternatively or in addition, a magnetic material with a lower saturation flux density can be used for the lower leg, and magnetic material with a higher saturation flux density can be use for the other legs, which leads to earlier saturation in the lower leg as well.

Fig. 2 shows another example of a current controlling element 1b, which is quite similar to the current controlling element 1a of Fig. 1. In contrast, a resistor 7 is switched between the two controlled current terminals TCI1, TCI2. In this way, the range, in which the total resistance between the two controlled current terminals TCI1, TCI2 varies, can be set or influenced. Moreover, the resistor 7 provides an alternative electric path for the electric (short circuit) current so that electric energy can be dissipated in the resistor 7 when the magnetoresistive conductor 5 cuts off current. Thus, undesired heat up of the magnetoresistive conductor 5 can be avoided.

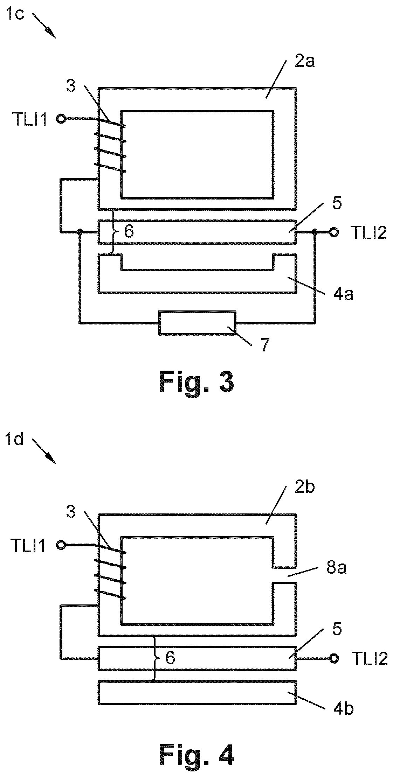

Fig. 3 shows another example of a current controlling element 1c, which is quite similar to the current controlling element 1b of Fig. 2. In contrast, the current controlling element 1c comprises two auto current limiter terminals TLI1, TLI2 and a series connection of the coil 3 and the magnetoresistive conductor 5 switched in-between. In this way, the current in an electric circuit, which the current controlling element 1c is part of, can be limited. Hence, the current controlling element 1c becomes a "current limiting element" in this embodiment, e.g. a circuit breaker. Generally, a resistor 7 may be switched in parallel with the magnetoresistive conductor 5 or not.

Fig. 4 shows another example of a current controlling element 1d, which is similar to the current controlling element 1c of Fig. 3. In contrast, there is no resistor 7, the second magnetic core 4b is shaped differently to the second magnetic core 4a (it is bar-shaped instead of U-shaped) and the first magnetic core 2b does not form a closed magnetic circuit without a second air gap (case a), but an open magnetic circuit having a second air gap 8a (case b). The second air gap 8a provides the advantage, that the current through the coil 3, which flows when the first magnetic core 2b saturates, and thus the switching threshold can be controlled. The length of the second air gap 8a preferably is chosen in a way that the first magnetic core 2b saturates when the nominal current is reached.

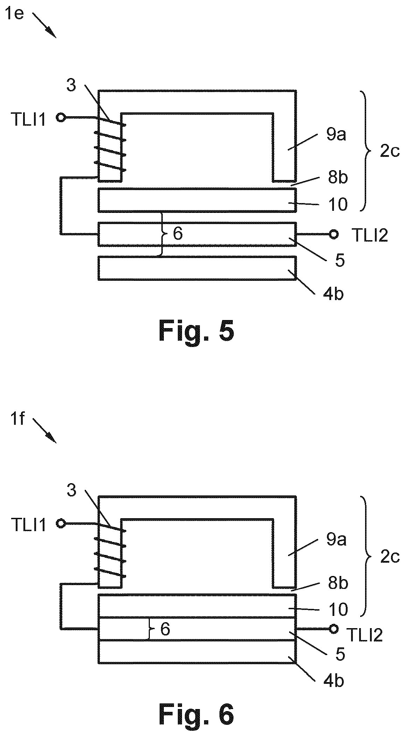

Fig. 5 shows another example of a current controlling element 1e, which is similar to the current controlling element 1d of Fig. 4. In contrast, there are two second air gaps 8b, and the first magnetic core 2c comprises a first sub part 9a and a separate second sub part 10 with the second air gaps 8b in-between. This is an alternative embodiment to control when saturation of the first magnetic core 2c starts and when the switching threshold is reached. The length of the second air gaps 8b preferably is chosen in a way that the second sub part 10 saturates when the nominal current is reached. After the second sub part 10 has been saturated, an additional magnetic flux is transferred into the second magnetic core 4b. Preferably, the second sub part 10 saturates well before any saturation effects occur the first sub part 9a.

Fig. 6 shows another example of a current controlling element 1f, which is similar to the current controlling element 1e of Fig. 5. In contrast, the magnetoresistive conductor 5 contacts the first magnetic core 2c and the second magnetic core 4b, in detail the second sub part 10 and the second magnetic core 4b. This configuration enables good heat transfer and keeps the magnetoresistive conductor 5 comparably cool.

Fig. 7 shows another example of a current controlling element 1g, which is similar to the current controlling element 1f of Fig. 6. In contrast, the first sub part 9b is not U-shaped, but M-shaped or E-shaped. In this way there are three areas, in which the magnetic flux traverses the magnetoresistive conductor 5, instead of two. This may contribute to vary the resistance of the magnetoresistive conductor 5 in comparison to the embodiment shown in Figs. 1 to 6.

Figs. 8 to 10 now illustrate the function of the current controlling element 1g. Fig. 8 shows the magnetic flux in the current controlling element 1g in a current range below the nominal switching current I<Inom or below the switching threshold. As is visible, the flux lines are concentrated in the first magnetic core 9b and there is no or no substantial magnetic flux in the magnetoresistive conductor 5 and in the second magnetic core 4b.

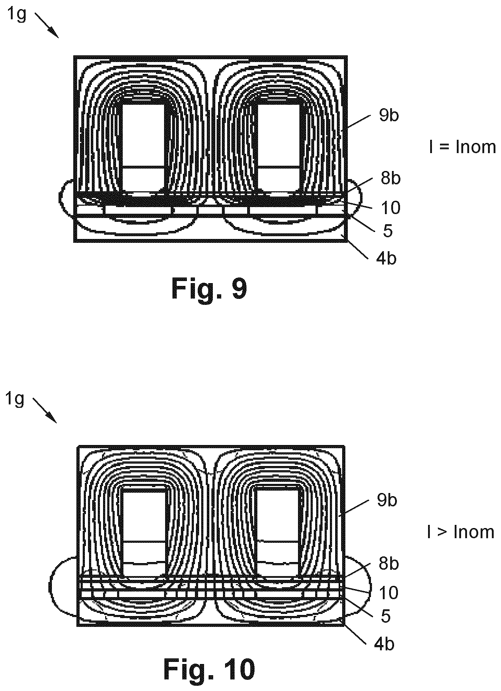

Fig.9 shows the magnetic flux in the current controlling element 1g at the nominal switching current I=Inom or at the switching threshold. As is visible, the flux lines are still concentrated in the first magnetic core 9b and the magnetic flux emanates into the magnetoresistive conductor 5 and into the second magnetic core 4b only to a low extent.

Fig. 10 finally shows the magnetic flux in the current controlling element 1g in a current range above the nominal switching current I>Inom or above the switching threshold. As is visible, the flux lines emanate into the magnetoresistive conductor 5 and into the second magnetic core 4b to a substantial extent. In particular, the magnetoresistive conductor 5 is traversed by a substantial number of flux lines.

It should be noted that the function illustrated in Figs. 8 to 10 is similar to or comparable with the function of all embodiments shown in Figs. 1 to 7. That is why the technical teaching disclosed in the context of Figs. 8 to 10 and disclosed hereinafter is applicable to all embodiments shown in Figs. 1 to 7.

To support or provide the behavior described above, a reluctance of the first magnetic core 2a..2d (alone) preferably is at least 10 times lower than a reluctance of first magnetic core 2a..2d together with the second magnetic core 4a, 4b. In this way, the magnetic flux is mainly kept within the first magnetic core 2a..2d up to the nominal switching current I>Inom or up to the switching threshold.

To support or provide the above behavior,
- a magnetic flux density in the first magnetic core 2a..2d preferably is at least 10 times the magnetic flux density in the second magnetic core 4a, 4b in a current range I < 0.9 · Inom and
- the magnetic flux density in the second magnetic core 4a, 4b preferably is at least 0.5 times the magnetic flux density in the first magnetic core 2a..2d in a current range I > 1.1 · Inom.

By designing the first magnetic core 2a..2d and the second magnetic core 4a, 4b in an appropriate way, in particular by setting air gaps 8a, 8b as well as by choosing the cross section and the material of the first magnetic core 2a..2d accordingly, the magnetic flux mainly exists in the first magnetic core 2a..2d below the nominal switching current Inom, and it emanates into the second magnetic core 4a, 4b at or above the nominal switching current Inom. It should be noted that there is no "binary" swap of the magnetic flux into the second magnetic core 4a, 4b in the sense of all or nothing, but the change is continuous, but also steep depending on the design as illustrated in Figs. 1 to 10.

As noted before, the desired behavior can be achieved by choosing appropriate cross sections for the first sub part 9b and the second sub part 10. In the example of Figs. 8 to 10 the cross section of the second sub part 10 is small compared to the cross section of the first sub part 9b. Hence, the second sub part 10 saturates well before any saturation effects occur the first sub part 9a.

Beneficially, the first magnetic core 2a..2d and/or the second magnetic core 4a, 4b is/are made of Vanadium permendur. Generally, the material of the first magnetic core 2a..2d and its cross section should be designed in a way that the magnetic flux up to the switching threshold can be handled. If Vanadium permendur is chosen, the cross section of the first magnetic core 2a..2d can be kept small. In a similar way, the second magnetic core 4a, 4b and its cross section should be designed in a way that the magnetic flux above the switching threshold can be handled. If Vanadium permendur is chosen, the cross section of the second magnetic core 4a, 4b can be kept small as well.

Preferably, the first sub part 9a, 9b is made of Vanadium permendur and/or the second sub part 10 is made of a Mu-metal, which is a nickel-iron soft ferromagnetic alloy. In addition, the second magnetic core 4a, 4b preferably can be made of Vanadium permendur, too. The way of this material choice supports the behavior of the first magnetic core 2c, 2d that the second sub part 10 saturates at the nominal current Inom and that the second sub part 10 saturates well before any saturation effects occur the first sub part 9a, 9b.

Generally, the current controlling element 1a..1f can comprise a housing (not shown in the Figs.) with a nominal switching current Inom for a current I through the coil 3 or an information referring to the nominal switching current Inom printed on the housing. Such an information can be a part number or a symbol or a color associated with a particular nominal switching current Inom.

Beneficially, the magnetoresistive conductor 5 has a semiconductor-metal hybrid structure and operates according to the Extraordinary magnetoresistance effect. The Extraordinary magnetoresistance (EMR) is a magnetoresistance effect, which allows changes of the electrical resistance caused the application of a magnetic field in the region of 1:10.000 and more. The effect occurs in semiconductor-metal hybrid systems when a transverse magnetic field is applied. Without a magnetic field the magnetoresistive conductor 5 has a low-resistance. Upon application of a magnetic field the magnetoresistive conductor 5 has a much higher electrical resistance. Accordingly, this material is well suited for "switching" applications. In particular, a switch-off characteristic or current-limiting characteristic can be provided, in other words a kind of a normally closed contact or break contact.

However, in principle, the resistance of the magnetoresistive conductor 5 may also decrease with an increase of the magnetic flux through the magnetoresistive conductor 5. In that way, a switch-on characteristic can be provided, in other words a kind of a normally open contact or closing contact.

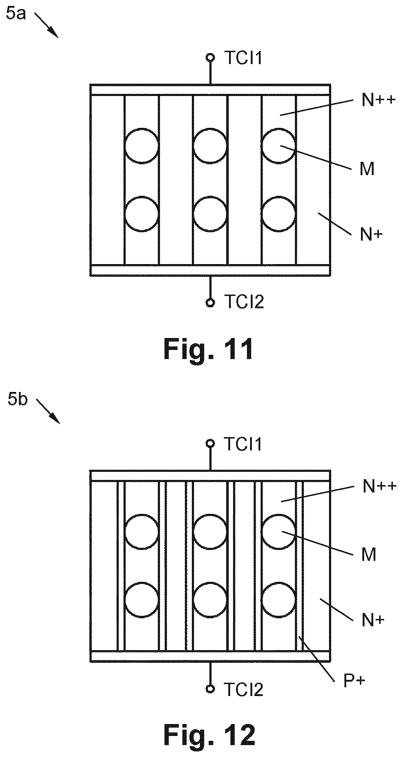

Fig. 11 shows a first exemplary structure of a magnetoresistive conductor 5a in cross sectional view. Between two controlled current terminals TCI1, TCI2 (alternatively between two auto current limiter terminals TLI1, TLI2) the magnetoresistive conductor 5a, comprises alternating negative doted layers N+ and highly negative doted layers N++, wherein metal parts M are embedded in the highly negative doted layers N++.

In an alternative embodiment of a magnetoresistive conductor 5b, which is shown in Fig. 12, there are positive doted layers P+ between the negative doted layers N+ and highly negative doted layers N++.

It should be noted that features of one embodiment may be applied to another embodiment as the case may be. For example, the resistor 7 may be part of any one of the embodiments depicted in Figs. 1 to 7. Further on, the current control function and the current limiting function is not linked to a particular design of the magnetic circuits, but it depends if the coil 3 and the magnetoresistive conductor 5 are switched in series or not.

It should also be noted that the term "comprising" does not exclude other elements and the use of articles "a" or "an" does not exclude a plurality. Also elements described in association with different embodiments may be combined. It should also be noted that reference signs in the claims should not be construed as limiting the scope of the claims.

### LIST OF REFERENCE NUMERALS

- 1a..1g: current controlling element
- 2a..2d: first magnetic core
- 3: coil
- 4a, 4b: second magnetic core
- 5, 5a, 5b: magnetoresistive conductor

- 6: first air gap
- 7: resistor
- 8a, 8b: second air gap
- 9a, 9b: first sub part of first magnetic core
- 10: second sub part of first magnetic core

- I: current
- Inom: nominal current
- TC1, TC2: control terminal
- TCI1, TCI2: controlled current terminal
- TLI1, TLI2: auto current limiter terminal

- N+: negative doted layer
- N++: highly negative doted layer
- M: metal part
- P+: positive doted layer

## Claims

1. Current controlling element (1a..1g), comprising
- a first magnetic core (2a..2d) forming a magnetic circuit,
- a coil (3), which is designed to generate a magnetic flux in the first magnetic core (2a..2d) when it its energized,
- a second magnetic core (4a, 4b) arranged at a distance from the first magnetic core (2a..2d),
- a magnetoresistive conductor (5, 5a, 5b) arranged in a first air gap (6) between the first magnetic core (2a..2d) and the second magnetic core (4a, 4b), wherein during operation an additional magnetic flux above saturation of the first magnetic core (2a..2d) is guided through the second magnetic core (4a, 4b) causing the magnetoresistive conductor (5, 5a, 5b) to be exposed to the magnetic field, and either:
two control terminals (TC1, TC2) with the coil (3) switched in-between and two controlled current terminals (TCI1, TCI2) with the magnetoresistive conductor (5, 5a, 5b) switched in-between, or
two auto current limiter terminals (TLI1, TLI2) and a series connection of the coil (3) and the magnetoresistive conductor (5, 5a, 5b) switched in-between.

2. Current controlling element (1a..1g) as claimed in claim 1, **characterized in that** the first magnetic core (2a..2d) forms a) a closed magnetic circuit without a second air gap (8a, 8b) or b) an open magnetic circuit having at least one second air gap (8a, 8b).

3. Current controlling element (1a..1g) as claimed in claim 2, **characterized in that** the first magnetic core (2a..2d) in case b) comprises a first sub part (9a, 9b) and a separate second sub part (10) with the at least one second air gap (8a, 8b) in-between.

4. Current controlling element (1a..1g) as claimed in any one of claims 1 to 3, **characterized in that** the magnetoresistive conductor (5, 5a, 5b) contacts the first magnetic core (2a..2d) and the second magnetic core (4a, 4b).

5. Current controlling element (1a..1g) as claimed in any one of claims 1 to 4, **characterized in that** a reluctance of the first magnetic core (2a..2d) is at least 10 times lower than a reluctance of first magnetic core (2a..2d) together with the second magnetic core (4a, 4b).

6. Current controlling element (1a..1g) as claimed in any one of claims 1 to 5, **characterized in that** the first magnetic core (2a..2d) and/or the second magnetic core (4a, 4b) is made of Vanadium permendur.

7. Current controlling element (1a..1g) as claimed in any one of claims 3 to 6, **characterized in that** the first sub part (9a, 9b) is made of Vanadium permendur and/or the second sub part (10) is made of a Mu-metal, which is a nickel-iron soft ferromagnetic alloy.

8. Current controlling element (1a..1g) as claimed in any one of claims 1 to 7, **characterized in that** the resistance of the magnetoresistive conductor (5, 5a, 5b) increases with an increase of the magnetic flux through the magnetoresistive conductor (5, 5a, 5b).

9. Current controlling element (1a..1g) as claimed in any one of claims 1 to 8, **characterized in that** the magnetoresistive conductor (5, 5a, 5b) has a semiconductor-metal hybrid structure and operates according to the Extraordinary magnetoresistance effect.

10. Current controlling (1a..1g) element as claimed in any one of claims 1 to 9, comprising the two control terminals (TC1, TC2) with the coil (3) switched in-between and the two controlled current terminals (TCI1, TCI2) with the magnetoresistive conductor (5, 5a, 5b) switched in-between, and a resistor (7) switched between the two controlled current terminals (TCI1, TCI2).

11. Current controlling element (1a..1g) as claimed in any one of claims 1 to 9, comprising the two auto current limiter terminals (TLI1, TLI2) and the series connection of the coil (3) and the magnetoresistive conductor (5, 5a, 5b) switched in-between, and a resistor (7) switched between the two auto current limiter terminals (TLI1, TLI2).

12. Current controlling element (1a..1g) as claimed in any one of claims 1 to 11, **characterized in** a nominal switching current Inom for a current I through the coil (3), wherein
- a magnetic flux density in the first magnetic core (2a..2d) is at least 10 times the magnetic flux density in the second magnetic core (2a..2d) in a current range I < 0.9 · Inom and wherein
the magnetic flux density in the second magnetic core (2a..2d) is at least 0.5 times the magnetic flux density in the first magnetic core (2a..2d) in a current range I > 1.1 · Inom.

13. Current controlling element (1a..1g) as claimed in claim 12, **characterized in** a housing with the nominal switching current Inom for the current I through the coil (3) or an information referring to the nominal switching current Inom printed on the housing.

## Patentansprüche

1. Stromsteuerungselement (1a..1g), umfassend:
- einen ersten Magnetkern (2a..2d), der einen Magnetkreis bildet,
- eine Spule (3), die dazu ausgebildet ist, einen Magnetfluss in dem ersten Magnetkern (2a..2d) zu erzeugen, wenn er mit Energie versorgt wird,
- einen zweiten Magnetkern (4a, 4b), der in einem Abstand von dem ersten Magnetkern (2a..2d) angeordnet ist,
- einen magnetoresistiven Leiter (5, 5a, 5b), der in einem ersten Luftspalt (6) zwischen dem ersten Magnetkern (2a..2d) und dem zweiten Magnetkern (4a, 4b) angeordnet ist, wobei während des Betriebs ein zusätzlicher Magnetfluss oberhalb der Sättigung des ersten Magnetkerns (2a..2d) durch den zweiten Magnetkern (4a, 4b) geleitet wird, wodurch der magnetoresistive Leiter (5, 5a, 5b) dem Magnetfeld ausgesetzt wird, und
entweder:
zwei Steueranschlüsse (TC1, TC2) mit dazwischen geschalteter Spule (3) und zwei gesteuerte Stromanschlüsse (TCI1, TCI2) mit dazwischen geschaltetem magnetoresistiven Leiter (5, 5a, 5b)
oder
zwei automatische Strombegrenzeranschlüsse (TLI1, TLI2) und eine Reihenschaltung der Spule (3) und des dazwischen geschalteten magnetoresistiven Leiters (5, 5a, 5b).

2. Stromsteuerungselement (1a..1g) nach Anspruch 1, **dadurch gekennzeichnet, dass** der erste Magnetkern (2a..2d) a) einen geschlossenen Magnetkreis ohne zweiten Luftspalt (8a, 8b) oder b) einen offenen Magnetkreis mit mindestens einem zweiten Luftspalt (8a, 8b) bildet.

3. Stromsteuerungselement (1a..1g) nach Anspruch 2, **dadurch gekennzeichnet, dass** der erste Magnetkern (2a..2d) im Fall b) einen ersten Teilabschnitt (9a, 9b) und einen separaten zweiten Teilabschnitt (10) mit dem mindestens einen zweiten Luftspalt (8a, 8b) dazwischen umfasst.

4. Stromsteuerungselement (1a..1g) nach einem der Ansprüche 1 bis 3, **dadurch gekennzeichnet, dass** der magnetoresistive Leiter (5, 5a, 5b) den ersten Magnetkern (2a..2d) und den zweiten Magnetkern (4a, 4b) berührt.

5. Stromsteuerungselement (1a..1g) nach einem der Ansprüche 1 bis 4, **dadurch gekennzeichnet, dass** eine Reluktanz des ersten Magnetkerns (2a..2d) mindestens 10-mal geringer als eine Reluktanz des ersten Magnetkerns (2a..2d) zusammen mit dem zweiten Magnetkern (4a, 4b) ist.

6. Stromsteuerungselement (1a..1g) nach einem der Ansprüche 1 bis 5, **dadurch gekennzeichnet, dass** der erste Magnetkern (2a..2d) und/oder der zweite Magnetkern (4a, 4b) aus Vanadiumpermendur hergestellt sind/ist.

7. Stromsteuerungselement (1a..1g) nach einem der Ansprüche 3 bis 6, **dadurch gekennzeichnet, dass** das erste Teilstück (9a, 9b) aus Vanadiumpermendur hergestellt ist und/oder das zweite Teilstück (10) aus einem Mu-Metall hergestellt ist, das eine weiche ferromagnetische Nickel-Eisen-Legierung ist.

8. Stromsteuerungselement (1a..1g) nach einem der Ansprüche 1 bis 7, **dadurch gekennzeichnet, dass** der Widerstand des magnetoresistiven Leiters (5, 5a, 5b) mit einer Zunahme des Magnetflusses durch den magnetoresistiven Leiter (5, 5a, 5b) zunimmt.

9. Stromsteuerungselement (1a..1g) nach einem der Ansprüche 1 bis 8, **dadurch gekennzeichnet, dass** der magnetoresistive Leiter (5, 5a, 5b) eine Halbleiter-Metall-Hybridstruktur aufweist und entsprechend dem außergewöhnlichen Magnetowiderstandseffekt betrieben wird.

10. Stromsteuerungselement (1a..1g) nach einem der Ansprüche 1 bis 9, umfassend die zwei Steueranschlüsse (TC1, TC2) mit der dazwischen geschalteten Spule (3) und die zwei gesteuerten Stromanschlüsse (TCI1, TCI2) mit dem dazwischen geschalteten magnetoresistiven Leiter (5, 5a, 5b) und einen Widerstand (7), der zwischen die zwei gesteuerten Stromanschlüsse (TCI1, TCI2) geschaltet ist.

11. Stromsteuerungselement (1a..1g) wie in einem der Ansprüche 1 bis 9 beansprucht, umfassend die zwei automatischen Strombegrenzeranschlüsse (TLI1, TLI2) und die Reihenschaltung der Spule (3) und des magnetoresistiven Leiters (5, 5a, 5b), die dazwischen geschaltet sind, und einen Widerstand (7), der zwischen die zwei automatischen Strombegrenzeranschlüsse (TLI1, TLI2) geschaltet ist.

12. Stromsteuerungselement (1a..1g) nach einem der Ansprüche 1 bis 11, **gekennzeichnet durch** einen Nennschaltstrom Inom für einen Strom I durch die Spule (3), wobei
- eine Magnetflussdichte in dem ersten Magnetkern (2a..2d) mindestens das 10-fache der Magnetflussdichte in dem zweiten Magnetkern (2a..2d) in einem Strombereich I < 0,9 • Inom beträgt und wobei
- die Magnetflussdichte in dem zweiten Magnetkern (2a..2d) mindestens das 0,5-fache der Magnetflussdichte in dem ersten Magnetkern (2a..2d) in einem Strombereich I > 1,1 • Inom beträgt.

13. Stromsteuerungselement (1a..1g) nach Anspruch 12, **gekennzeichnet durch** ein Gehäuse mit dem Nennschaltstrom Inom für den Strom I durch die Spule (3) oder eine auf dem Gehäuse aufgedruckte Information über den Nennschaltstrom Inom.

## Revendications

1. Élément de régulation de courant (1a..1g), comprenant
- un premier noyau magnétique (2a..2d) formant un circuit magnétique,
- une bobine (3), conçue pour générer un flux magnétique dans le premier noyau magnétique (2a..2d) lorsqu'elle est alimentée,
- un second noyau magnétique (4a, 4b) agencé à distance du premier noyau magnétique (2a..2d),
- un conducteur magnétorésistif (5, 5a, 5b) agencé dans un premier entrefer (6) entre le premier noyau magnétique (2a..2d) et le second noyau magnétique (4a, 4b), dans lequel, pendant le fonctionnement, un flux magnétique supplémentaire dépassant la saturation du premier noyau magnétique (2a..2d) est guidé à travers le second noyau magnétique (4a, 4b), ce qui amène le conducteur magnétorésistif (5, 5a, 5b) à être soumis au champ magnétique, et
soit :
deux bornes de commande (TC1, TC2) avec la bobine (3) intercalée entre celles-ci et deux bornes de courant régulé (TCI1, TCI2) avec le conducteur magnétorésistif (5, 5a, 5b) intercalé entre celles-ci, soit
deux bornes de limiteur de courant automatique (TLI1, TLI2) et un montage en série de la bobine (3) et du conducteur magnétorésistif (5, 5a, 5b) intercalé entre celles-ci.

2. Élément de régulation de courant (1a..1g) selon la revendication 1, **caractérisé en ce que** le premier noyau magnétique (2a..2d) forme a) un circuit magnétique fermé sans second entrefer (8a, 8b) ou b) un circuit magnétique ouvert présentant au moins un second entrefer (8a, 8b).

3. Élément de régulation de courant (1a..1g) selon la revendication 2, **caractérisé en ce que**, dans le cas b), le premier noyau magnétique (2a..2d) comprend une première sous-partie (9a, 9b) et une seconde sous-partie (10) distincte, l'au moins un second entrefer (8a, 8b) étant interposé entre celles-ci.

4. Élément de régulation de courant (1a..1g) selon l'une quelconque des revendications 1 à 3, **caractérisé en ce que** le conducteur magnétorésistif (5, 5a, 5b) est en contact avec le premier noyau magnétique (2a..2d) et le second noyau magnétique (4a, 4b).

5. Élément de régulation de courant (1a..1g) selon l'une quelconque des revendications 1 à 4, **caractérisé en ce qu'**une réluctance du premier noyau magnétique (2a..2d) est au moins 10 fois inférieure à une réluctance du premier noyau magnétique (2a..2d) avec le second noyau magnétique (4a, 4b).

6. Élément de régulation de courant (1a..1g) selon l'une quelconque des revendications 1 à 5, **caractérisé en ce que** le premier noyau magnétique (2a..2d) et/ou le second noyau magnétique (4a, 4b) est constitué de permendur au vanadium.

7. Élément de régulation de courant (1a..1g) selon l'une quelconque des revendications 3 à 6, **caractérisé en ce que** la première sous-partie (9a, 9b) est constituée de permendur au vanadium et/ou la seconde sous-partie (10) est constituée de Mu-métal, qui est un alliage ferromagnétique doux de nickel et de fer.

8. Élément de régulation de courant (1a..1g) selon l'une quelconque des revendications 1 à 7, **caractérisé en ce que** la résistance du conducteur magnétorésistif (5, 5a, 5b) augmente avec une augmentation du flux magnétique traversant le conducteur magnétorésistif (5, 5a, 5b).

9. Élément de régulation de courant (1a..1g) selon l'une quelconque des revendications 1 à 8, **caractérisé en ce que** le conducteur magnétorésistif (5, 5a, 5b) présente une structure hybride semiconducteur-métal et fonctionne selon l'effet de magnétorésistance extraordinaire.

10. Élément de régulation de courant (1a..1g) selon l'une quelconque des revendications 1 à 9, comprenant les deux bornes de commande (TC1, TC2) avec la bobine (3) intercalée entre celles-ci et les deux bornes de courant régulé (TCI1, TCI2) avec le conducteur magnétorésistif (5, 5a, 5b) intercalé entre celles-ci, et une résistance (7) intercalée entre les deux bornes de courant régulé (TCI1, TCI2).

11. Élément de régulation de courant (1a..1g) selon l'une quelconque des revendications 1 à 9, comprenant les deux bornes de limiteur de courant automatique (TLI1, TLI2) et le montage en série de la bobine (3) et du conducteur magnétorésistif (5, 5a, 5b) intercalé entre celles-ci, et une résistance (7) intercalée entre les deux bornes de limiteur de courant automatique (TLI1, TLI2).

12. Élément de régulation de courant (1a..1g) selon l'une quelconque des revendications 1 à 11, **caractérisé par** un courant de commutation nominal Inom pour un courant I traversant la bobine (3), dans lequel
- une densité de flux magnétique dans le premier noyau magnétique (2a..2d) est au moins 10 fois la densité de flux magnétique dans le second noyau magnétique (2a..2d) dans une plage de courant I < 0,9 • Inom et dans lequel
- la densité de flux magnétique dans le second noyau magnétique (2a..2d) est au moins 0,5 fois la densité de flux magnétique dans le premier noyau magnétique (2a..2d) dans une plage de courant I > 1,1 • Inom.

13. Élément de régulation de courant (1a..1g) selon la revendication 12, **caractérisé par** un boîtier avec le courant de commutation nominal Inom pour le courant I traversant la bobine (3) ou une information faisant référence au courant de commutation nominal Inom imprimée sur le boîtier.
